# EUROPÄISCHE PATENTSCHRIFT

(11) **EP 0 485 395 B1**
(45) Veröffentlichungstag und Bekanntmachung des Hinweises auf die Patenterteilung: **15.12.1993**
(21) Anmeldenummer: 90910113.1
(22) Anmeldetag: 10.07.1990
(51) Int. Cl.: H01F 7/22, H01F 5/08

(54) **SUPRALEITENDE HOMOGENE HOCHFELDMAGNETSPULE**
SUPERCONDUCTING HOMOGENEOUS INTENSE-FIELD MAGNETIC COIL
BOBINE MAGNETIQUE SUPRACONDUCTRICE HOMOGENE A CHAMP ELEVE

(30) Priorität: 15.07.1989 DE 3923456
(43) Veröffentlichungstag der Anmeldung: 20.05.1992
(73) Patentinhaber: BRUKER Analytische Messtechnik GmbH, 76287 Rheinstetten (DE)
(72) Erfinder: ROTH, Gerhard, D-7500 Karlsruhe 1 (DE); TSCHOPP, Werner, CH-8127 Aesch/Forch (CH)
(74) Vertreter: KOHLER SCHMID + PARTNER
(86) Internationale Anmeldenummer: DE9000517
(87) Internationale Veröffentlichungsnummer: WO9101564

(56) Entgegenhaltungen:
- DE-A- 2 045 978
- FR-A- 1 209 196
- FR-A- 1 404 437
- FR-A-15 116 77
- PATENT ABSTRACTS OF JAPAN, vol. 10, no. 233 (E-427)(2289), 13 August 1986; & JP-A-61 65411
- PATENT ABSTRACTS OF JAPAN, vol. 11, no. 314 (E-549)(2761), 13 October 1987; & JP-A-62 109303
- IEEE TRANSACTIONS ON MAGNETICS, vol. 23, no. 2, March 1987, New York US, pages 565-568, M. Takeo e.a.:"A 17 tesla superconducting magnet with multifilamentary superconductors"
- IEEE TRANSACTIONS ON MAGNETICS, vol. 24, no. 2, March 1988, New York, US, pages 1409-1412, P.A. Jonas e.a.: "12 tesla superconducting multifilamentary magnet"
- PATENT ABSTRACTS OF JAPAN, vol. 5, no. 34 (E-48)(706), 4 March 1981, & JP-A-55 160405

## Beschreibung

Die Erfindung betrifft eine supraleitende homogene Hochfeldmagnetspule, die zur Erzeugung eines statischen Magnetfeldes in Verbindung mit einem Kernresonanzspektrometer eingesetzt wird.

Die Erfindung geht aus von einer mehrlagigen Spule, wie sie z.B. aus Journal of Physics E, Scientific Instruments, 1972, Seite 944-946 bekannt ist. Bei der bekannten Spule ist im mittleren Längenbereich die Stromdichte durch passives Zuwickeln eines Drahts in mehreren Lagen verringert, um ein homogenes Magnetfeld zu erzeugen.

Aus Patent Abstracts of Japan, Vol. 10, Nummer 233 (JP-A-6 165 411) ist es bekannt, in den Endbereichen durch passiv zugewickelte Drähte die mittlere Stromdichte zu verringern. Die Druckschrift zeigt allerdings eine einlagige Spule und der Zweck liegt darin, den lokalen Anstieg des Magnetfelds im Endteil der Spule zu begrenzen, um zu verhindern, daß die kritische Feldstärke im Supraleiter überschritten wird. Ein Hinweis, daß diese Anordnung dazu verwendet werden soll, um den Druck innerhalb der Spule, der durch die Lorentz-Kräfte erzeugt wird, zu verringern, ist nicht enthalten. Es wird das Problem der Feldüberhöhung bei extrem dünnen, einlagigen Solenoidspulen behandelt, das bei mehrlagigen Spulen prinzipiell nicht auftritt. Der aufintegrierte Druck ist dort kein Problem.

Um Magnetfelder hoher Magnetfeldstärke (mehrere Tesla) zu erzeugen, werden unter anderem supraleitende Magnetspulen eingesetzt, die aus Wicklungslagen eines supraleitfähigen Drahtes aufgebaut sind und mindestens einen annähernd rotationssymmetrischen, hohlzylinderförmigen Wicklungsabschnitt aufweisen. Um die Supraleitfähigkeit des Drahtmaterials, beispielsweise Nb₃Sn mit Kupferstabilisierung, bei der erforderlichen Stromstärke und dem im Drahtbereich herrschenden Magnetfeld zu gewährleisten, arbeiten die Magnetfeldspulen in Kryostaten, die im genannten Beispiel mittels flüssigen Heliums auf eine Temperatur von 4,2 K abkühlbar sind. Außer den für höchste Felder geeigneten Supraleitern vom A15-Typ, zu denen auch das Nb₃Sn gehört, wurden in jüngster Zeit auch supraleitende Materialien bekannt, die einen Einsatz im Magnetbau auch weit oberhalb 4,2 K, etwa bei der Temperatur des flüssigen Stickstoffs, in näherer Zukunft als möglich erscheinen lassen.

Aufgrund der Radialkomponente des durch die Magnetspule erzeugten Magnetfeldes treten in den Wicklungen durch Lorentzkräfte hervorgerufene axiale Drücke auf. Die axialen Lorentzkräfte sind umso größer, je größer die Radialkomponente des Magnetfeldes ist, sie sind also im Bereich der beiden Spulenenden am größten. Die dadurch hervorgerufenen axialen Drücke addieren sich jedoch zur Spulenmitte hin auf, so daß der maximale axiale Druck im Bereich der Spulenmitte herrscht. Diese Drücke erreichen bei Hochfeldmagnetspulen in der Spulenmitte eine Größenordnung von 50 Megapascal (P. Turowski et al., 9th International Conference on Magnet Technology, p. 394, 1985) und können während des Ladevorgangs des Magneten, insbesondere an Stellen, an denen die Wicklung nicht homogen ist, Leiterbewegungen verursachen, die aufgrund der durch die Bewegung erzeugten Wärme den Übergang des Drahtes in den normalleitenden Zustand verursachen. Da sich der normalleitende Bereich trotz der niederohmigen Kupferstabilisierung aufgrund des elektrischen Widerstandes weiter aufheizt, wird schnell die gesamte Magnetspule normalleitend.

Zur Erzeugung höchster Magnetfelder werden die bekannten Hochfeldmagnetspulen auch bei 1,8 K betrieben, um eine höhere Stromtragfähigkeit des Leiters zu erzielen (siehe beispielsweise P. Turowski, Th. Schneider in 2nd High Field Conference Leuven 1988).

Supraleitende Hochfeldmagnetspulen, die zum Erzeugen sehr homogener Magnetfelder im Innern des Hohlzylinders verwendet werden, haben im Gegensatz zu nicht homogenisierten Magneten eine grössere Spulenlänge und sind mit Zusatzspulen ausgerüstet, welche diejenigen Magnetfeldkomponenten der Hochfeldmagnetspule kompensieren, die am stärksten die Abhängigkeit der Magnetfeldstärke von der axialen Lage bezeichnen. Solche Zusatzspulen werden häufig ganz außen auf den Magnet aufgebracht, meist sogar werden sie auf einen separaten Spulenkörper gewickelt (siehe z.B. J.E.C. Williams et al., IEEE Transactions on Magnetics, Vol. 25, p. 1767). Diese zusätzlichen Magnetspulen können aber auch dadurch realisiert werden, daß in die Wicklungen selbst Bereiche eingebracht werden, in denen die Stromdichte gegenüber den umliegenden Wicklungsbereichen erniedrigt ist (siehe dazu beispielsweise L. Cesnak und D. Kabat, Journal of Physics E. Scientific Instruments 944, 1972). Ein solcher Bereich hat die Wirkung einer Zusatzspule mit negativer Stromdichte. Diese Art der Homogenisierung hat den Vorteil, daß die Zusatzspule direkt keinen zusätzlichen Bauraum beansprucht und daß die homogenisierenden Bereiche ohne weiteres radial weiter innen in der Wicklung angebracht werden können, wodurch ihre Wirksamkeit erhöht wird. Der zu homogenisierende Feldbereich befindet sich dabei in der Spulenmitte, da hier das Magnetfeld axial verläuft und die Abhängigkeit der Magnetfeldstärke von der axialen Lage am geringsten ist. Daher sind auch die Bereiche verringerter Stromdichte zur Homogenisierung des Magnetfeldes in der Spulenmitte angeordnet.

Supraleitende Hochfeldmagnete zur Erzeugung eines sehr homogenen Magnetfeldes der genannten Art, wie sie z.B. in der NMR-Spektroskopie eingesetzt werden, haben daher zum einen den Nachteil, daß aufgrund der groben erforderlichen Spulenlänge der maximale Axialdruck besonders groß ist (der Axialdruck summiert sich nämlich in jeder Wicklungslage über die einzelnen Windungen von den Spulenenden zur Spulenmitte hin auf, so daß sein Betrag mit der Spulenlänge anwächst) und zum anderen den Nachteil, daß durch das Einbringen der Bereiche verringerter Stromdichte Grenzflächen entstehen zwischen den Bereichen normaler Stromdichte und den homogensierenden Bereichen mit erniedrigter bzw. verschwindender Stromdichte. Die zulässigen Axialdrücke an diesen Grenzflächen sind erheblich niedriger als in homogenen Lagen der Wicklung. Dies hat zur Folge, daß die erreichbare Magnetfeldstärke in supraleitenden Magnetspulen zur Erzeugung homogener Magnetfelder geringer ist als in nicht homogenisierten Magnetspulen. Die mit bekannten supraleitenden Hochfeldmagnetspulen erreichbaren Magnetfeldstärken bei homogenisiertem Magnetfeld liegen bei 14 Tesla, während mit nicht homogenisierten Magnetspulen Magnetfeldstärken von bis zu 20 Tesla erreichbar sind. Typisch für einen homogenisierten Magneten zur Verwendung mit einem NMR-Spektrometer ist, daß die Grundhomogenität so gut ist, daß eine Homogenität von ΔB/Bo < 10 ppm und in Verbindung mit einem supraleitenden Shimsystem eine Homogenität von ΔB/Bo < 1 ppm über einen axialen Bereich der Länge > 30 mm erzielt wird. Je nach Spulentyp sind dabei die derzeit bei Magneten für die NMR-Spektroskopie erreichbaren Magnetfeldstärken unterschiedlich. So sind bei einem "Standard Bore" Hochfeldmagneten mit einer Raumtemperaturbohrung von 51,5 mm Durchmesser 14,1 T die derzeit maximal erreichbare Feldstärke. Bei einem "Wide Bore" Magneten mit 89 mm Raumtemperaturbohrung sinkt dieser Wert auf 11,7 T und bei einem "Super Wide Bore" Magneten mit 150 mm Durchmesser der Raumtemperaturbohrung auf 7 T. Je nach Bautyp ist also unter Hochfeldmagnet ein anderer bislang maximal erreichter Feldbereich zu verstehen.

Durch die Angabe im Anspruch 1 "vom Strom nur in Serie durchflossen" soll deutlich gemacht werden, daß der supraleitende Draht, der aus einem supraleitfähigen Material und einem normal leitenden Material besteht, keinerlei Verzweigungen enthält. Bei Vorhandensein von Verzweigungen gibt es keinen definierten Strompfad, so daß Spulen mit derartigen Verzweigungen nicht für die Erzeugung von homogenen Magnetfeldern geeignet sind, denn es ist ungewiß, auf welchem der jeweils vorhandenen Pfade der Gesamtstrom fließt oder ob und in welchem Verhältnis er sich auf die beiden Pfade aufteilt.

Der Erfindung liegt die Aufgabe zugrunde, die aufgrund der notwendigen größeren Baulänge bei zu homogenisierenden Magneten auftretenden größeren Kräfte so zu beherrschen, daß eine stabile Supraleitung in der Spule gewährleistet ist. Erreicht wird die Kräftebeherrschung dadurch, daß eine Kräfteumverteilung von überlasteten Spulenbereichen in weniger belastete Bereiche vorgenommen wird. Dies eröffnet bei homogenen Magneten die Möglichkeit, eine größere Feldstärke als bislang üblich zu erzielen. Umgekehrt bietet das nachstehend beschriebene Verfahren der Kräfteumverteilung auch die Möglichkeit, die bei nicht homogenisierten supraleitenden Magneten derzeit maximal beherrschten Feldstärken weiter zu erhöhen. Die genannte Kräfteumverteilung oder Druckumverteilung ist so zu verstehen, daß die erfindungsgemäße Spule im Vergleich zu einer bekannten Spule in einigen Teilen der Spule eine verringerte Druckbelastung und in anderen Teilen der Spule eine vergrößerte Druckbelastung aufweist. Es versteht sich, daß die erfindungsgemäße Spule vollständig berechnet werden muß.

Die erfindungsgemäße supraleitende Hochfeldmagnetspule mit den kennzeichnenden Merkmalen des Hauptanspruchs hat den Vorteil, daß die axiale Druckbelastung in jeder zunächst zu stark belasteten Wicklungslage unter den empirisch bestimmten zulässigen Höchstwert absenkbar ist. Die axiale Druckbelastung einer Wicklungslage ergibt sich angenähert als Summe über die Beiträge der einzelnen Windungen dieser Lage. Die Größe des Beitrags jeder einzelnen Windung hängt dabei von der Stromdichte im Leiter sowie von der radialen Magnetfeldstärke am Ort der Windung ab.

Bei der Erfindung ist die Stromdichte "in mehreren Wicklungslagen" verringert. Dies impliziert, daß der supraleitende Draht eine konstante Höhe (in radialer Richtung der Spule gemessen), bei Verwendung von Runddraht einen konstanten Durchmesser, aufweist, denn sonst wäre die Erzeugung von mehreren Wicklungslagen, die jeweils eine gleichmäßige Dicke aufweisen müssen, nicht möglich.

Da die Beiträge zum aufsummierten Axialdruck aus dem Randbereich der Spule wegen der dort vorliegenden größeren Radialkomponente des Magnetfeldes am größten sind, ist die Anordnung der Bereiche verringerter Stromdichte in den Spulenendbereichen besonders wirkungsvoll. Dabei müssen sich die Bereiche verringerter Stromdichte nicht unbedingt bis zum Spulenende erstrecken. Die Anordnung der Bereiche verringerter Stromdichte in der Spulenmitte dagegen erbrächte kaum eine Verringerung der axialen Druckbelastung.

Bei der Erfindung ist der Begriff "Stromdichte" nicht als "Stromdichte im supraleitfähigen Material" zu verstehen, denn eine bloße Vergrößerung der Querschnittsfläche des supraleitfähigen Materials auf Kosten der Querschnittsfläche des Kupfers würde bei der Erfindung nicht zu dem angestrebten Erfolg führen. Vielmehr handelt es sich bei der "Stromdichte in mindestens einer Wicklungslage" um die mittlere Stromdichte in einem Flächenelement des Wicklungsquerschnitts, das z.B. mindestens zwei Drahtquerschnitte umfaßt (damit der unter Umständen vorhandene passiv zugewickelte Draht mit erfaßt wird).

Bei der Erfindung wird an einer von der eingangs genannten Druckschrift abweichenden Stelle, nämlich im Endbereich einer Wicklung, die Stromdichte in mehreren Lagen verringert, und zwar um die auf den supraleitenden Draht wirkende Lorentzkraft zu verringern. Die erfindungsgemäße Maßnahme kann bei Teilwicklungen Anwendung finden, die in ihrem mittleren Bereich die normale Stromdichte haben, wie dies beispielsweise bei der Teilwicklung S4 des Ausführungsbeispiels der Fall ist. Die Erfindung kann aber auch mit besonderem Vorteil bei solchen Teilwicklungen verwendet werden, bei denen, wie bei der eingangs genannten Druckschrift, im mittleren Bereich eine verringerte Stromdichte vorhanden ist, die beispielsweise durch passives Zuwickeln eines nicht vom Strom durchflossenen Drahts erzeugt wird und die gegen zu starken Druck besonders empfindlich ist.

Bei entsprechender Ausführung des supraleitenden Hochfeldmagneten mit einer erfindungsgemäßen Magnetspule können höhere homogene Magnetfelder als bisher erzeugt werden. Dies ist dadurch möglich, daß an den Stellen, an denen die zulässige Grenze der axialen Druckbelastung überschritten würde, eine lokale Druckabsenkung durchgeführt wird.

Insgesamt ergibt sich durch das Einbringen von Bereichen verringerter Stromdichte gemaß der Erfindung die Möglichkeit, die Magnetwicklung über einen weiten radialen Bereich gezielt mit der für jeden Radius zulässigen Belastung zu betreiben, d.h. überlastete Wicklungslagen zu entlasten und unterforderte Lagen höher zu belasten, da das Einbringen von Bereichen verringerter Stromdichte in Wicklungslagen zu einer Erhöhung der axialen Druckbelastung in Wicklungslagen ohne einen solchen Bereich führt. Dies deshalb, weil die in den Bereichen mit verringerter Stromdichte fehlenden Windungen an anderer Stelle hinzugefügt werden müssen.

Nach einer vorteilhaften Ausgestaltung der Erfindung sind die Bereiche verringerter Stromdichte symmetrisch bezüglich einer Ebene angeordnet, die senkrecht zur Spulenlängsachse in der Mitte der Spule verläuft. Wie bereits weiter oben dargelegt, ist der Beitrag der einzelnen Windungen einer Wicklungslage zur axialen Druckbelastung umso größer, je näher die Windung am Spulenende ist, so daß eine Verringerung umso effektiver ist, je weiter außen sie in der Spule angeordnet ist. Eine maximale Absenkung der Stromdichte am Spulenende auf Null ist gleichbedeutend mit einer Verkürzung der Wicklungslänge in der betreffenden Lage.

Nach einer vorteilhaften Ausgestaltung der Erfindung sind zusätzlich im Bereich der Spulenmitte ein oder mehrere Bereiche verringerter Stromdichte vorgesehen. Diese homogenisierenden Bereiche verringerter Stromdichte in der Spulenmitte werden, sofern die Druckbelastung dort zunächst größer ist als der zulässige Maximalwert, durch Einbringen von Bereichen verringerter Stromdichte im Bereich des Spulenendes in derselben radialen Lage (nämlich Position) und Ausdehnung wie die homogenisierenden Bereiche druckentlastet. Dies hat den Vorteil, daß im Innern des von der Magnetspule umfaßten Hohlzylinders ein homogenes Magnetfeld erzeugt werden kann, ohne daß die Gefahr besteht, daß wegen der geringeren axialen Druckbelastbarkeit der Grenzflächen zwischen dem homogenisierenden Bereich und dem dichter gewickelten Bereich die Supraleitfähigkeit zerstört wird.

Nach einer vorteilhaften Ausgestaltung der Erfindung erfolgt der Übergang in radialer Richtung von einem Bereich verringerter Stromdichte zu einem Bereich normaler Stromdichte stufenweise. Dadurch ergibt sich der Vorteil, daß die erhebliche Reduktion des axialen Druckes schrittweise wieder abgebaut wird.

Nach einer anderen vorteilhaften Ausgestaltung der Erfindung erfolgt der Übergang in radialer Richtung von einem Bereich verringerter Stromdichte zu einem Bereich normaler Stromdichte quasi kontinuierlich in Schritten, wie sie die Drahtdicke zuläßt. Dies hat ebenfalls den Vorteil, daß die erhebliche Reduktion des axialen Druckes langsam wieder abgebaut wird.

Nach weiteren vorteilhaften Ausgestaltungen der Erfindung erfolgt der stufenweise oder quasi kontinuierliche Übergang in radialer Richtung zwischen einem Bereich verringerter Stromdichte und einem Bereich normaler Stromdichte durch entsprechende Änderung der axialen Ausdehnung des Bereiches verringerter Stromdichte und/oder durch eine entsprechende Änderung des Betrages der negativen Stromdichte von Wicklungslage zu Wicklungslage im Übergangsbereich.

Weitere Merkmale und Vorteile der Erfindung ergeben sich aus der folgenden Beschreibung eines Ausführungsbeispiels anhand der Zeichnung, die erfindungswesentliche Einzelheiten zeigt, und aus den Ansprüchen. Die einzelnen Merkmale können je einzeln für sich oder zu mehreren in beliebiger Kombination bei einer Ausführungsform der Erfindung verwirklicht sein. Es zeigen:
- Fig. 1: eine erfindungsgemäße supraleitende Hochfeldmagnetspule mit 4 Wicklungsabschnitten im Längsschnitt in stark vereinfachter Darstellung,
- Fig. 2: eine graphische Darstellung der axialen Druckbelastung in dieser Spule,
- Fig. 3a und 3b: zwei Beispiele des Übergangs von normaler Stromdichte zu verringerter Stromdichte.

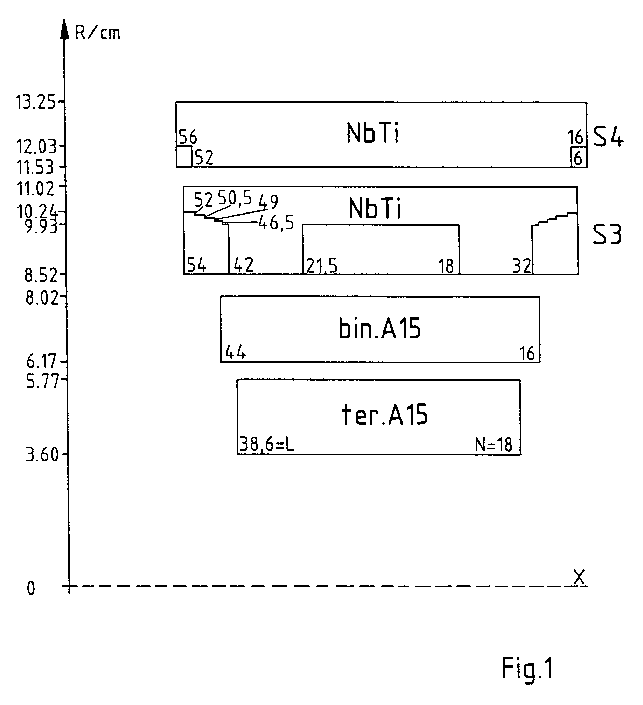

Die in Fig. 1 in sehr vereinfachter Darstellung wiedergegebene supraleitende Hochfeldmagnetspule besteht aus 4 Wicklungsabschnitten, von denen jeweils nur die in der Schnittebene gelegenen Konturen gezeigt sind. Die Spulenform ergibt sich durch die Rotation des Schnittbildes um die Rotationsachse X, die gleichzeitig die Spulenlängsachse darstellt. Senkrecht zur Achse X ist eine zweite Achse eingezeichnet, auf der der radiale Abstand R zur Spulenlängsachse in Zentimetern aufgetragen ist. Die vier Wicklungsabschnitte S1 bis S4 der Spule sind hinsichtlich des supraleitfähigen Materials unterschiedlich ausgeführt. Während die beiden äußeren Wicklungsabschnitte S3 und S4 aus Wicklungen eines Niob-Titan-Drahtes mit Stabilisierungskupfer aufgebaut sind, wird im zweitinnersten Wicklungsabschnitt S2 ein binärer A15-Supraleiter und im innersten Wicklungsabschnitt S1 ein ternärer A15-Supraleiter jeweils mit einem stabilisierenden Kupferkern als Drahtmaterial verwendet. Die gesamte Spule ist symmetrisch bezüglich einer Ebene ausgeführt, die senkrecht zur Spulenlängsachse X in der Mitte der Spule verläuft. Der Radius des von der Magnetspule umfaßten Hohlzylinders beträgt ca. 3,6 cm. Der innerste Wicklungsabschnitt S1 hat eine axiale Länge von ca. 38,6 cm und eine radiale Dicke von ca. 2,2 cm. Der zweitinnerste Wicklungsabschnitt S2 hat zum ersten Wicklungsabschnitt S1 einen Abstand von ca. 0,4 cm, eine axiale Länge von ca. 44 cm und eine radiale Ausdehnung von ca. 1,8 cm. Der zweitäußerste Wicklungsabschnitt S3 hat zum zweitinnersten S2 einen Abstand von ca. 0,5 cm, eine axiale Länge von ca. 54 cm, eine radiale Dicke von ca. 2,5 cm und weist 32 Wicklungslagen auf. Es wird ein NbTi-Rechteckleiter mit 54 Filamenten und 57,4% Stabilisierungskupfer mit den Abmessungen 0,78 x 1,24 mm² verwendet. Der äußerste Wicklungsabschnitt S4 hat zum zweitäußersten S3 einen Abstand von ca. 0,5 cm, eine axiale Länge von ca. 56 cm, eine radiale Ausdehnung von etwa 1,7 cm und besteht aus 22 Wicklungslagen. Hier wird ein NbTi-Rechteckleiter mit nur noch 36 Filamenten und einem auf 80% erhöhten Kupferanteil verwendet. Die Abmessungen betragen wiederum 0,78 x 1,24 mm². Der innerste Wicklungsabschnitt S1 und der zweitinnerste Wicklungsabschnitt S2 sind homogen durchgewickelt. Der zweitäußerste Wicklungsabschnitt S3 weist einen symmetrisch um die Spulenmittelachse angeordneten Bereich mit auf 50% verringerter Stromdichte auf, der in der ersten Wicklungslage beginnt und sich bis zur 18. Wicklungslage erstreckt und eine axiale Ausdehnung con ca. 21,5 cm aufweist. Dieser Bereich verringerter Stromdichte dient der Homogenisierung des Magneten und bewirkt, daß die relative Feldänderung in einem axialen Bereich von ± 30 mm um die Spulenmitte kleiner als 10 ppm ist. Ebenfalls symmetrisch zur Spulenmittelebene und ebenfalls in der ersten Wicklungslage beginnend ist in den beiden Spulenendbereichen je ein weiterer Bereich verringerter Stromdichte vorgesehen, der sich bis zur 22. Wicklungslage erstreckt. Die axiale Ausdehnung jedes dieser beiden Bereiche beträgt von der ersten bis zur 18. Wicklungslage ca. 6 cm und nimmt ab der 19. Wicklungslage in mehreren Stufen unterschiedlicher Länge (Längen von 2,25 cm, 1,25 cm, 0,75 cm, 0,75 cm, 1 cm) ab. (Die im linken Endbereich der Wicklung S3 eingetragenen Zahlen beziehen sich auf die Summe der jeweiligen Längenangaben beider Spulenendbereiche.)

Der äußerste Wicklungsabschnitt S4 weist wiederum symmetrisch zur Spulenmittelebene zwei Bereiche mit auf 80% verringerter Stromdichte in den beiden Spulenendbereichen auf, die sich über die Lagen 1-6 erstrecken. Eine Abstufung der Länge beim Übergang zur vollen Wicklungslänge ist wegen der hier nur geringen Änderung des axialen Druckes nicht notwendig.

Die dargestellte supraleitende Hochfeldmagnetspule weist bei einem Betriebsstrom von 187,4 A eine Induktionsflußdichte von 14,1 Tesla auf und besitzt eine Induktivität von 43,8 Henry. Die aufgenommene Energie beträgt 770 kJ. Die Hochfeldmagnetspule wird im supraleitenden Kurzschlu betrieben und hat eine zeitliche Feldänderung (Drift) von weniger als 10⁻⁷ pro Stunde. Der axiale Homogenitätsbereich der Magnetspule, bei dem sich die Induktionsflußdichte um weniger als 10 ppm ändert, hat eine Länge von ≧ 60 mm und erfüllt damit die für Magnete zur Verwendung in der NMR-Spektroskopie üblicherweise gestellten Grundvoraussetzungen.

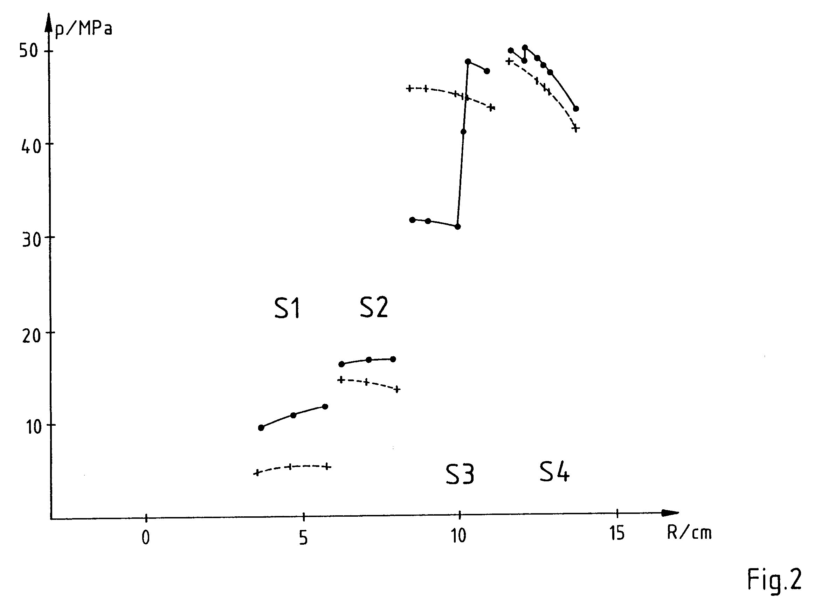

Fig. 2 zeigt eine graphische Darstellung der axialen Druckbelastung p in den 4 Wicklungsabschnitten und zwar ist die axiale Druckbelastung in Megapascal über dem die Wicklunglagen kennzeichnenden Spulenradius R aufgetragen. In den beiden inneren Wicklungsabschnitten ist der axiale Druck noch sehr niedrig. Dagegen ist in den beiden äußeren Wicklungsabschnitten die axiale Druckbelastung sehr hoch. Hier kann ein Bereich verringerter Stromdichte in der Spulenmitte nur eingebracht werden, wenn die axiale Druckbelastung in den betroffenen Wicklungslagen verringert wird. Dies geschieht erfindungsgemäß durch zusätzliches Einbringen von Bereichen verringerter Stromdichte in den beiden Spulenendbereichen. Diese Bereiche sind in Abstufungen auf benachbarte Wicklungslagen ausgedehnt, um die erhebliche Reduktion des axialen Druckes schrittweise wieder abzubauen. Außerdem wird dadurch eine Reduktion des in diesem Wicklungsabschnitt maximal auftretenden axialen Druckes erreicht. In den inneren Lagen des äußersten Wicklungsabschnittes S4 würde der axiale Druck zunächst einen Wert von 50 MPa übersteigen. Durch die in den inneren Wicklungslagen im Spulenendbereich eingebrachten Bereiche verringerter Stromdichte kann die maximale Druckbelastung wieder unter 50 MPa abgesenkt werden. In Fig. 2 ist die Druckbelastung in den einzelnen Wicklungslagen ohne ausgleichende Maßnahmen als gestrichelte Linie dargestellt, während die durchgezogene Linie die Druckbelastung bei Einbringen von Ausgleichsbereichen an den Spulenenden kennzeichnet. Man erkennt, daß nicht nur die kritischen Wicklunglagen druckentlastet werden, sondern daß auch die Druckbelastung in andere, unkritische Wicklungslagen umverteilt wird.

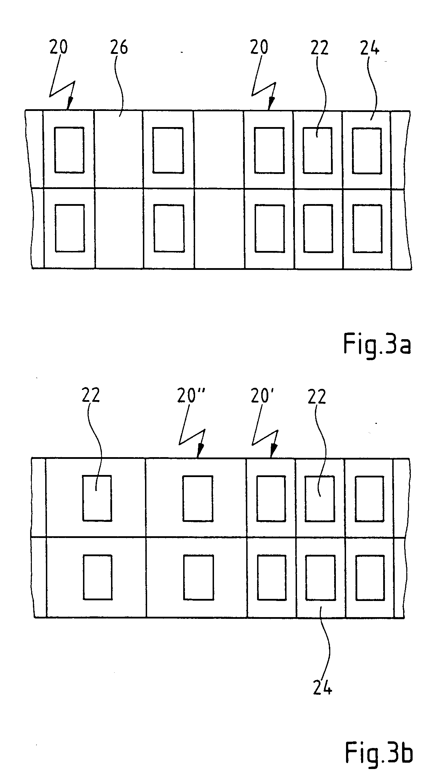

Fig. 3a zeigt abgebrochen im Querschnitt zwei Lagen der Wicklung S3 im linken Übergangsbereich zum Bereich verringerter Stromdichte. Der supraleitfähige Draht 20 ist Rechteckdraht mit den oben genannten Abmessungen. Das supraleitfähige Material 22 ist von einem Mantel 24 aus Kupfer umgeben. Im rechten Teil der Fig. 3a herrscht im Betrieb die normale mittlere Stromdichte. Im linken Teil herrscht eine nur halb so große Stromdichte, weil ein sogenannter Blinddraht 26, der zumindest im supraleitenden Betrieb der Anordnung nicht von Strom durchflossen ist, hinzugewickelt ist, so daß sich der Abstand von Mitte zu Mitte zwischen den einzelnen Windungen des Drahts 20 verdoppelt. Die gleiche Anordnung kann bei Verwendung von Runddraht angewendet werden. Der Vorteil der Anordnung nach Fig. 3a liegt darin, daß der Draht innerhalb jeder Wicklungslage ohne Lötstelle gewickelt werden kann.

Fig. 3b stimmt im rechten Teil mit Fig. 3a überein. Im linken Teil geht bei diesem Beispiel der supraleitende Draht 20', der auch hier Kupfer und supraleitfähiges Material enthält, in einen Draht 20'' über, der doppelt so breit ist wie der Draht 20', wobei aber der Querschnitt des supraleitfähigen Materials in den Drähten 20' und 20'' gleich groß ist.

Für die Wicklungsabschnitte S1 und S2 können zum Beispiel folgende Werkstoffe verwendet werden:
supraleitende Materialien NbTi und/oder ein A15-Supraleiter, z.B. Nb₃Sn und/oder Nb₃SnTa bzw. Nb₃SnTi und/oder YBa₂Cu₃Oₓ oder Bi₂Sr₂CaCu₂O₈ oder Tl₂Ba₂CaCu₂O₈ oder Tl₂Ba₂Ca₂Cu₃O₁₀ oder eine andere oxidische Materialkombination verwendet werden.

Der Übergang von einem Gebiet verringerter Stromdichte in ein Gebiet normaler Stromdichte muß nicht wie in Fig. 1 gezeigt abrupt oder durch Verändern der axialen bzw. radialen Ausdehnung des Bereichs erfolgen, sondern kann auch quasi-kontinuierlich durch Verändern der Dicke (in Längsrichtung der Spule) bzw. der Anzahl von passiv zugewickelten Drähten (wie beispielsweise von L. Cesnak und D. Kabat in Journal of Physics E: Scientific Instruments 944,1972 beschrieben) erreicht werden. Diese können, müssen aber nicht, denselben Querschnitt wie der Supraleiterdraht haben bzw. können auch ein rechteckiges Profil aufweisen.

Bei Ausführungsformen der Erfindung können folgende Merkmale einzeln oder in beliebiger Kombination vorliegen:

Der Übergang in axialer Richtung erfolgt durch entsprechende axiale Änderung der verringerten Stromdichte in den einzelnen Wicklunglagen.

Die Hochfeldmagnetspule weist mindestens zwei radial ineinander geschachtelte Wicklungen S1, S2, S3, S4 auf.

Die supraleitenden Drähte mindestens zweier Wicklungen enthalten unterschiedliche supraleitende Materialien.

Als supraleitende Materialien werden NbTi und ein A15-Supraleiter, wie zum Beispiel Nb₃Sn und/oder Nb₃SnTa bzw. Nb₃SnTi verwendet.

Als supraleitende Materialien werden oxidische Hochtemperatursupraleiter verwendet, die bei Temperaturen ≧ 77 K supraleitend sind und als Kühlmittel flüssigen Stickstoff zulassen.

Als supraleitendes Material wird YBa₂Cu₃Oₓ oder Bi₂Sr₂CaCu₂O₈ oder Tl₂Ba₂CaCu₂O₈ oder Tl₂Ba₂Ca₂Cu₃O₁₀ oder eine andere oxidische Materialkombination verwendet.

Die Hochfeldmagnetspule ist für supraleitenden Kurzschlußbetrieb geeignet.

Der axiale Homogenitätsbereich der Hochfeldmagnetspule mit B/Bo < 10 ppm erstreckt sich über mindestens 30 mm.

Die Hochfeldmagnetspule ist Teil eines Kernresonanzspektrometers.

Die Hochfeldmagnetspule ist Teil eines Ionenzyklotronresonanzspektrometers.

Die Hochfeldmagnetspule ist Teil einer Spektrometeranordnung für die Kernspintomographie.

Die Hochfeldmagnetspule ist Teil einer Spektrometeranordnung für die Kernresonanzmikroskopie.

## Patentansprüche

1. Supraleitende Hochfeldmagnetspule zum Erzeugen eines homogenen starken Magnetfeldes mit mindestens einem annähernd rotationssymmetrischen, hohlzylinderförmigen Wicklungsabschnitt aus mehreren Lagen von Windungen eines vom Strom nur in Serie durchflossenen supraleitfähigen Drahtes (20), wobei im axialen Endbereich mindestens eines Wicklungsabschnitts radiale Komponenten des Magnetfeldes vorliegen, die zu axialen Lorentz-Kräften sowie zum Aufbau axialer Drücke in den Wicklungslagen führen, wobei mehrere Wicklungslagen jeweils mindestens zwei Bereiche unterschiedlicher mittlerer Stromdichte, nämlich mit normaler Stromdichte und mit verringerter Stromdichte der Querschnittsfläche der Wicklungslage aufweisen und im Bereich der Spulenmitte mindestens ein Bereich verringerter Stromdichte vorhanden ist, der sich über mehrere Wicklungslagen erstreckt und der Homogenisierung des Magnetfeldes innerhalb eines Homogenitätsvolumens im Bereich der Spulenmitte im Inneren des Hohlzylinders dient,
dadurch gekennzeichnet, daß
in beiden axialen Endbereichen mindestens eines Wicklungsabschnitts (S3, S4) die Stromdichte in jeweils mehreren Wicklungslagen gegenüber der in dem an den Endbereich angrenzenden Bereich vorliegenden normalen Stromdichte verringert ist, so daß dadurch die in diesen Wicklungslagen aufgrund der auf den Draht (20) wirkenden Lorentz-Kräfte maximal auftretenden axialen Drücke in zulässigen Grenzen gehalten werden.

2. Hochfeldmagnetspule nach Anspruch 1, dadurch gekennzeichnet, daß in beiden axialen Endbereichen mindestens eines Wicklungsabschnitts (S3, S4) die Stromdichte in denjenigen Wicklungslagen, in denen der zur Homogenisierung dienende Bereich mit verringerter Stromdichte vorhanden ist, gegenüber der in dem an den Endbereich angrenzenden Bereich vorliegenden normalen Stromdichte verringert ist, und daß in den übrigen Wicklungslagen der axialen Endbereiche ein Übergang auf die normale Stromdichte erfolgt.

3. Hochfeldmagnetspule nach Anspruch 1 oder 2, dadurch gekennzeichnet, daß in den genannten Endbereichen die Stromdichte dadurch verringert wird, daß durch passiv zugewickelte Drähte (26) der Abstand zwischen benachbarten Windungen des supraleitenden Drahts (20) vergrößert wird, oder daß als supraleitender Draht (20'') Rechteckdraht verwendet wird, dessen Breite in Bezug auf die Höhe größer ist als in dem benachbarten Bereich normaler Stromdichte.

4. Hochfeldmagnetspule nach einem der vorhergehenden Ansprüche, dadurch gekennzeichnet, daß die Spule ein Magnetfeld von mehr als 11,5 Tesla erzeugt.

5. Hochfeldmagnetspule nach einem der vorhergehenden Ansprüche, dadurch gekennzeichnet, daß die Spule ein Magnetfeld von mehr als 14 Tesla erzeugt.

6. Hochfeldmagnetspule nach einem der Ansprüche 1 bis 3,
dadurch
gekennzeichnet, daß die Spule ein Magnetfeld von mehr als 9,3 Tesla erzeugt und die bei der Betriebstemperatur vorhandene Bohrung des innersten Spulenkörpers mehr als 90 mm Durchmesser hat.

7. Hochfeldmagnetspule nach einem der vorhergehenden Ansprüche, dadurch gekennzeichnet, daß die Bereiche verringerter Stromdichte symmetrisch bezüglich einer Ebene angeordnet sind, die rechtwinklig zur Spulenlängsachse in der Mitte der Spule verläuft.

8. Hochfeldmagnetspule nach einem der vorhergehenden Ansprüche, dadurch gekennzeichnet, daß der Bereich verringerter Stromdichte sich nicht bis an das Ende des Wicklungsabschnitts erstreckt.

9. Hochfeldmagnetspule nach einem der vorhergehenden Ansprüche, dadurch gekennzeichent, daß der Übergang von einem Bereich verringerter Stromdichte zu einem benachbarten Bereich normaler Stromdichte stufenweise erfolgt.

10. Hochfeldmagnetspule nach einem der Ansprüche 1 bis 8, dadurch gekennzeichnet, daß der Übergang von einem Bereich verringerter Stromdichte zu einem benachbarten Bereich normaler Stromdichte kontinuierlich erfolgt.

## Claims

1. Superconducting high field magnetic coil for the production of a homogeneous strong magnetic field with at least an approximately rotationally symmetric hollow cylindrically shaped winding section comprised of a plurality of layers of windings of a superconducting wire (20) through which current is flowing only in series, whereby radial components of the magnetic field are present in the axial end region of at least one winding section which lead to axial Lorentz forces as well as to the accumulation of the axial pressures in the winding layers, whereby a plurality of winding layers each exhibit at least two regions of differing average winding layer cross sectional surface current density, namely with normal current density and with reduced current density and in the vicinity of the coil middle there is at least one region of reduced current density which extends over a plurality of winding layers and serves to homogenize the magnetic field within a homogeneous volume in the vicinity of the coil center within the hollow cylinder, characterized in that in both axial end regions of at least one coil section (S3, S4) the current density in each of a plurality of winding layers is reduced relative to that in the regions of normal current density which border on the end regions, such that the axial pressures which occur in consequence of the Lorentz forces acting on the wire (20) in these winding layers are thereby kept within allowable limits.

2. High field magnetic coil according to claim 1,
characterized in that in both axial end regions of at least one winding section (S3, S4), the current density in that winding layer in the region of reduced current density serving for the homogenization is reduced compared to that in the normal current density of the region bordering on the end region, and that, in the remaining winding layers of the axial end region, a transition to the normal current density is effected.

3. High field magnetic coil according to claim 1 or 2, characterized in that in the end regions mentioned the current density is reduced in that the separation between neighbouring windings of a superconducting wire (20) is increased through the addition of passive wire windings (26), or that rectangular wire is utilized as superconducting wire (20'') whose width in relationship to the height is larger than that in the neighbouring region of normal current density.

4. High field magnetic coil according to one of the preceding claims, characterized in that the coil produces a magnetic field in excess of 11.5 Tesla.

5. High field magnetic coil according to one of the preceding claims, characterized in that the coil produces a magnetic field in excess of 14 Tesla.

6. High field magnetic coil according to one of the claims 1 through 3, characterized in that the coil produces of magnetic field in excess of 9.3 Tesla and that, at the operating temperature, the available bore of the innermost coil body has a diameter in excess of 90 mm.

7. High field magnetic coil according to one of the preceding claims, characterized in that the region of reduced current density is arranged symmetrically with respect to a plane which runs at right angles to the lengthwise coil axis at the middle of the coil.

8. High field magnetic coil according to one of the preceding claims, characterized in that the region of reduced current density does not extend to the end of the winding sections.

9. High field magnetic coil according to one of the preceding claims, characterized in that the transition from a region of reduced current density to a neighbouring region of normal current density proceeds in a stepwise fashion.

10. High field magnetic coil according to one of the claims 1 through 8, characterized in that the transition from a region of reduced current density to a neighbouring region of normal current density transpires continuously.

## Revendications

1. Bobine magnétique supraconductrice à champ élevé pour créer un puissant champ magnétique homogène, comportant au moins une portion de bobinage approximativement symétrique en rotation, en forme de cylindre creux, constituée de plusieurs couches de spires d'un conducteur supraconducteur (20) parcouru uniquement en série par le courant, bobine dans laquelle, dans la zone terminale axiale d'au moins une portion du bobinage, existent des composantes radiales de champ magnétique qui conduisent à des forces de Lorentz axiales ainsi qu'à l'établissement de pressions axiales dans les couches du bobinage, bobine dans laquelle plusieurs couches du bobinage présentent chacune au moins deux zones de la surface de la section de la couche du bobinage de densité moyenne de courant différente, à savoir à densité du courant normale et à densité du courant réduite et dans laquelle, dans la zone du milieu de la bobine, il y a au moins une zone de densité du courant réduite qui s'étend sur plusieurs couches du bobinage et sert à l'homogénéisation du champ magnétique à l'intérieur d'un volume de champ magnétique homogène dans la zone du milieu de la bobine, à l'intérieur du cylindre creux,
bobine caractérisée,
par le fait que dans les deux zones terminales axiales d'au moins une portion (S3, S4) du bobinage, la densité du courant est réduite, dans respectivement plusieurs couches du bobinage, par rapport à la densité du courant normale existant dans la zone jouxtant la zone d'extrémité, de sorte que, de ce fait, les pressions axiales survenant à la valeur maximale dans ces couches du bobinage du fait des forces de Lorentz agissant sur le fil conducteur (20) sont maintenues dans des limites autorisées.

2. Bobine magnétique à champ élevé, selon la revendication 1, caractérisée par le fait que dans les deux zones terminales axiales d'au moins une portion S3-S4 du bobinage, la densité du courant est, dans les couches du bobinage dans lesquelles se trouve la zone à densité du courant réduite, servant à l'homogénéisation, réduite par rapport à la densité du courant normale existant dans la zone jouxtant la zone terminale, et par le fait que dans les autres couches du bobinage des zones terminales axiales se fait une transition pour arriver à la densité du courant normale.

3. Bobine magnétique à champ élevé selon la revendication 1 ou 2, caractérisée par le fait que, dans les zones terminales mentionnées, on réduit la densité du courant par le fait qu'au moyen de fils (26) bobinés en supplément, à action passive, on agrandit la distance entre les spires voisines du fil du conducteur supraconducteur (20), ou bien par le fait que l'on emploie comme fil conducteur supraconducteur (20'') du fil rectangulaire dont le rapport de la largeur à la hauteur est supérieur à ce qu'il est dans la zone voisine, de densité de courant normale.

4. Bobine magnétique à champ élevé selon l'une des revendicaions précédentes, caractérisée par le fait que la bobine produit un champ magnétique supérieur à 11,5 teslas.

5. Bobine magnétique à champ élevé selon l'une des revendications précédentes, caractérisée par le fait que la bobine produit un champ magnétique supérieur à 14 teslas.

6. Bobine magnétique à champ élevé selon l'une des revendications 1 à 3, caractérisée par le fait que la bobine produit un champ magnétique supérieur à 9,3 teslas et que l'alésage, à la température d'exploitation, du bobineau le plus intérieur a un diamètre supérieur à 90 mm.

7. Bobine magnétique à champ élevé selon l'une des revendications précédentes, caractérisée par le fait que les zones de densité de courant réduite sont disposées symétriquement par rapport à un plan passant dans le milieu de la bobine, perpendiculairement à l'axe longitudinal de la bobine.

8. Bobine magnétique à champ élevé selon l'une des revendications précédentes, caractérisée par le fait que la zone de densité de courant réduite ne s'étend pas jusqu'à l'extrémité de la portion du bobinage.

9. Bobine magnétique à champ élevé selon l'une des revendications précédentes, caractérisée par le fait que la transition pour passer d'une zone de densité de courant réduite à une zone voisine de densité de courant normale se fait par échelons.

10. Bobine magnétique à champ élevé selon l'une des revendications 1 à 8, caractérisée par le fait que la transition pour passer d'une zone de densité de courant réduite à une zone voisine de densité de courant normale se fait de façon continue.
